# EUROPEAN PATENT APPLICATION

(11) **EP 4 585 951 A1**
(43) Date of publication of application: **16.07.2025**
(21) Application number: 24151796.0
(22) Date of filing: 15.01.2024
(51) Int. Cl.: G01R 33/48, G01R 33/561, G01R 33/565

(54) **PARALLEL PROPELLER MR IMAGING**

(71) Applicant: Koninklijke Philips N.V., 5656 AG Eindhoven (NL)
(72) Inventor: EGGERS, Holger, Eindhoven (NL)
(74) Representative: Philips Intellectual Property & Standards

(57) **Abstract**

The invention relates to a method of MR imaging of a body (10) of a patient. It is an object of the invention to provide a method that reduces the artefact level in parallel (accelerated) PROPELLER imaging. According to the proposed invention,

MR signals are acquired in parallel via a number of RF receiving antennas (11, 12, 13) having different spatial sensitivity profiles, wherein the MR signals are acquired from a plurality of k-space blades (21-26) in temporal succession according to a PROPELLER scheme. The k-space blades (21-26) are rotated about the center of k-space, with the total acquired set of MR signals spanning a circle (28) in k-space and a common central region (27) of k-space being covered by all k-space blades (21-26). The MR-signal acquisition from the respective k-space blades (21-26) involves subsampling of k-space, wherein the density of k-space sampling is varied depending on the rotation angle. Finally, an MR image is computed by combining the MR signals acquired via the different RF receiving antennas (11, 12, 13) utilizing their spatial sensitivity profiles to perform a parallel image reconstruction. Moreover, the invention relates to an MR system (1) and to a computer program for an MR system (1).

## Description

### FIELD OF THE INVENTION

The invention relates to the field of magnetic resonance (MR) imaging. It concerns a method of MR imaging of a body of a patient placed in the examination volume of an MR system. The invention also relates to an MR system and to a computer program to be run on an MR system.

### BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation and are usually not invasive.

So-called PROPELLER imaging offers advantages for clinical MR imaging like robustness against patient motion and intrinsic motion compensation capabilities. In the PROPELLER concept (see Pipe et al, Magnetic Resonance in Medicine, 42:963-969, 1999), MR signal data are acquired in k-space in *N* strips, each consisting of *L* parallel k-space lines, corresponding to the *L* lowest frequency phase-encoding lines in a Cartesian-based k-space sampling scheme. Each strip, which is referred to herein as k-space blade, is rotated in k-space by an angle of, e.g., 180°/*N*, so that the total set of MR signals spans a circle in k-space. If a full k-space data matrix having a diameter *M* is desired, then *L and N* may be chosen so that *Z*×*N=M*×π/2*.* One essential characteristic of conventional PROPELLER is that a central circular portion in k-space, having a diameter *L*, is acquired for each k-space blade. This central portion can be used to reconstruct a low-resolution MR image for each k-space blade. The low-resolution MR images can be compared to each other to estimate and compensate for patient motion. For example, in-plane translation and rotation between the k-space blades can be removed in this way. Thus, the PROPELLER technique makes use of oversampling in the central portion of k-space in order to obtain an MR image acquisition technique that is robust with respect to motion of the examined patient during MR signal acquisition. Moreover, due to the averaging of k-space blades PROPELLER to a certain extent `averages out' different types of imaging artefacts.

The primary drawback associated with PROPELLER is the extended scan time. Various studies have explored the application of parallel imaging acceleration to PROPELLER as a means to mitigate this limitation (see Chang et al., Magnetic Resonance in Medicine, 74:1598-1608, 2015). Parallel imaging acceleration has the potential to widen the k-space blades (as the sampling density in the phase-encoding direction of each k-space blade is decreased), thereby reducing scan time by requiring fewer blades to cover the entire k-space. Nonetheless, noise and artefacts are a concern in accelerated PROPELLER, particularly at high acceleration rates. The noise and artefact level not only impact image quality but also influence the accuracy of motion correction. In the common reconstruction strategy for accelerated PROPELLER, each k-space blade is reconstructed separately using parallel image reconstruction, and subsequently all single blade images are combined with motion correction. While the efficacy of this approach has been convincingly demonstrated at relatively low acceleration rates, at higher acceleration rates, certain limitations of the method become apparent, particularly in terms of subsampling artefacts and noise amplification. It turns out that the conditioning of the parallel image reconstruction can be highly dependent on the orientation of the individual k-space blades. This leads to pronounced artefacts and noise. A small number of poorly conditioned blades with similar orientation can significantly escalate the noise and artefact level in the final (combined) MR image. It has been observed that this problem persists even if all blades are reconstructed jointly in one step into the final MR image in order to better make use of the complementary information of the different blades as proposed by Lyu et al. (Scientific Reports 2017, 7:42602).

### SUMMARY OF THE INVENTION

From the foregoing it is readily appreciated that there is a need for an improved PROPELLER MR imaging technique. It is an object of the invention to provide a method that reduces the artefact level in parallel (accelerated) PROPELLER imaging.

In accordance with the invention, a method of MR imaging of a body of a patient placed in the examination volume of an MR system is disclosed. The method comprises the steps of:
- generating MR signals by subjecting at least a portion of the body to an MR imaging sequence comprising a number of RF pulses and switched magnetic field gradients;
- acquiring the MR signals in parallel via a number of RF receiving antennas having different spatial sensitivity profiles, wherein the MR signals are acquired from a plurality of k-space blades in temporal succession according to a PROPELLER scheme, wherein the k-space blades are rotated about the center of k-space, with the total acquired set of MR signals spanning a circle in k-space and a common central region of k-space being covered by all k-space blades, the MR-signal acquisition from the respective k-space blades involving subsampling of k-space, wherein the density of k-space sampling is varied depending on the rotation angle; and
- computing an MR image by combining the MR signals acquired via the different RF receiving antennas utilizing their spatial sensitivity profiles to perform a parallel image reconstruction.

The invention suggests the acquisition of k-space blades according to the known PROPELLER scheme in combination with parallel imaging. In order to achieve an acceleration of MR signal acquisition by parallel imaging, subsampling of k-space is applied. The invention proposes to vary the extent of subsampling (in the phase-encoding direction of the Cartesian sampling of the individual k-space blades) depending on the rotation angle of the respective k-space blade. Varying the sampling density means that the acceleration factor is varied from k-space blade to k-space blade. The k-space blades therefore differ from each other in terms of the acceleration factor, i.e. in terms of the distance between adjacent actually acquired (parallel) k-space lines relative to the distance between adjacent nominally (without parallel imaging acceleration) acquired (parallel) k-space lines. This allows to adapt the subsampling of each k-space blade to the capabilities of the employed RF receiving antennas (RF coils) to support the parallel image reconstruction for the respective orientation of the k-space blade. As a result, artefacts can be reduced in the final MR image.

It is within the scope of the invention that MR signal acquisition without subsampling can be applied for some of the rotation angles. However, at least for a subset of k-space blades subsampling has to be applied to achieve an acceleration.

In an embodiment, all k-space blades include the same number of parallel and equidistant k-space lines, but have different widths in the respective phase-encoding direction. Varying the width of the k-space blades is one possible way of varying the density of the (homogeneous) k-space sampling depending on the rotation angle of the respective k-space blade. In the case of an anisotropic k-space resolution, the acceleration factor depends not only on the width of the k-space blade in the respective phase-encoding direction, but also on the desired k-space resolution in this direction. Therefore, the density of the (homogeneous) k-space sampling can in principle also be varied without varying the actual width of the k-space blades, which is also within the scope of the invention.

In a possible embodiment, the parallel image reconstruction is performed according to the SENSE reconstruction method (see Pruessman et al., Magnetic Resonance in Medicine, 42:952-962, 1999). It can be combined with a compressed sensing (CS) reconstruction method (see Lustig et al. Magnetic Resonance in Medicine, 58:1182-1195, 2007). However, other known parallel imaging techniques may also be combined with the approach of the invention. In SENSE, estimates of the spatial sensitivity profiles of the used RF receiving antennas are utilized in the step of computing the MR image. These estimates may be obtained, e.g., in a corresponding pre-scan as it is known as such in the art.

In a possible embodiment, the variation of the width of the k-space blades depending on the rotation angle is determined by an (essentially) elliptical shape of the common central region of k-space. The long parallel edges (parallel to each other and parallel to the k-space lines) of each rectangular k-space blade are tangential to the common central region of k-space. Due to the elliptical shape, the k-space blade whose k-space lines are parallel to the semi-major axis of the ellipse has a minimum width, i.e. the homogeneous k-space sampling of this blade is the densest, while the k-space blade whose k-space lines are parallel to the semi-minor axis of the ellipse has a maximum width, i.e. the density of the homogeneous sampling is the lowest there. Accordingly, the directions of the highest and lowest sampling density are perpendicular to each other. The ratio of the highest and lowest widths of the k-space blades is defined by the ratio of the semi major and semi minor axes of the elliptical shape. Furthermore, the elliptical shape ensures that the widths of the k-space blades are continuously varied depending on the angle of rotation, from the minimum value for the direction parallel to the semi-major axis to the maximum value in the direction perpendicular thereto, i.e. parallel to the semi-minor axis. The term `elliptical shape' used herein is meant to exclude a circular shape, although, in the strict mathematical sense, a circle is a special case of an ellipse (with zero eccentricity). In possible embodiments, the eccentricity of the elliptical shape is larger than 0.1, preferably larger than 0.2, more preferably larger than 0.5, most preferably larger than 0.7. The eccentricity is a parameter that can be tuned, e.g. by an operator, to achieve a desired image quality (in terms of the level of artefacts and noise).

In another embodiment, the semi-minor axis of the elliptical shape is oriented in a direction, in which the differences between the spatial sensitivity profiles of the RF receiving antennas are less pronounced than in a direction perpendicular thereto. This means, in other words, that the directions of the semi-major and semi-minor axes of the elliptical shape are selected, e.g. by an operator, such that the sampling density is highest for the k-space blades for which the conditioning of the parallel image reconstruction is worst. Small differences in the spatial sensitivities give rise to a poor conditioning of the parallel image reconstruction. This can be taken into account according to the invention by choosing the appropriate orientation and eccentricity of the elliptical shape in the image plane such that the employed RF antennas support parallel image reconstruction for both the worst and best conditioned blade orientations. At the same time, the invention enables achieving a good compromise between image quality and acquisition speed.

In yet another embodiment, the k-space blade having a minimum density of k-space sampling is oriented in a direction, in which the body of the patient extends the furthest from the center of the examination volume of the MR system. The parallel imaging reconstruction is affected by inaccurate estimates of the spatial sensitivity profiles of the used RF receiving antennas in this direction in particular. Again, this can be taken into account according to the invention by choosing the appropriate orientations of the k-space blades with maximum and minimum density of k-space sampling, respectively.

As in conventional PROPELLER imaging, the method of the invention may also comprise the step of estimating and compensating for patient motion. For example, low-resolution MR images reconstructed from the common central region of k-space are compared to each other to remove in-plane translation and rotation between the k-space blades. These factors should be corrected for in each k-space blade in accordance with the invention prior to further processing the MR signals. This renders the method of the invention robust with respect to motion of the examined patient during MR signal acquisition.

The method of the invention described thus far can be carried out by means of an MR system including at least one main magnet coil for generating a uniform, steady magnetic field B₀ within an examination volume, a number of gradient coils for generating switched magnetic field gradients in different spatial directions within the examination volume, at least one body RF coil for generating RF pulses within the examination volume, a number of RF receiving antennas having different spatial sensitivity profiles for receiving MR signals from a body of a patient positioned in the examination volume, a control unit for controlling the temporal succession of RF pulses and switched magnetic field gradients, and a reconstruction unit for reconstructing MR images from the received MR signals. The method of the invention can be implemented by a corresponding programming of the reconstruction unit and/or the control unit of the MR system. The (parallel) image reconstruction may also be performed on a separate (remote) computer which is not part of the MR system.

The method of the invention can be advantageously carried out on most MR systems in clinical use at present. To this end it is merely necessary to utilize a computer program by which the MR system is controlled such that it performs the above-explained method steps of the invention. The computer program may be present either on a data carrier or be present in a data network so as to be downloaded for installation in the control and/or reconstruction unit of the MR system.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Fig. 1 shows an MR system for carrying out the method of the invention;
Fig. 2 schematically illustrates the modified PROPELLER acquisition scheme of the invention.

### DETAILED DESCRIPTION OF THE EMBODIMENTS

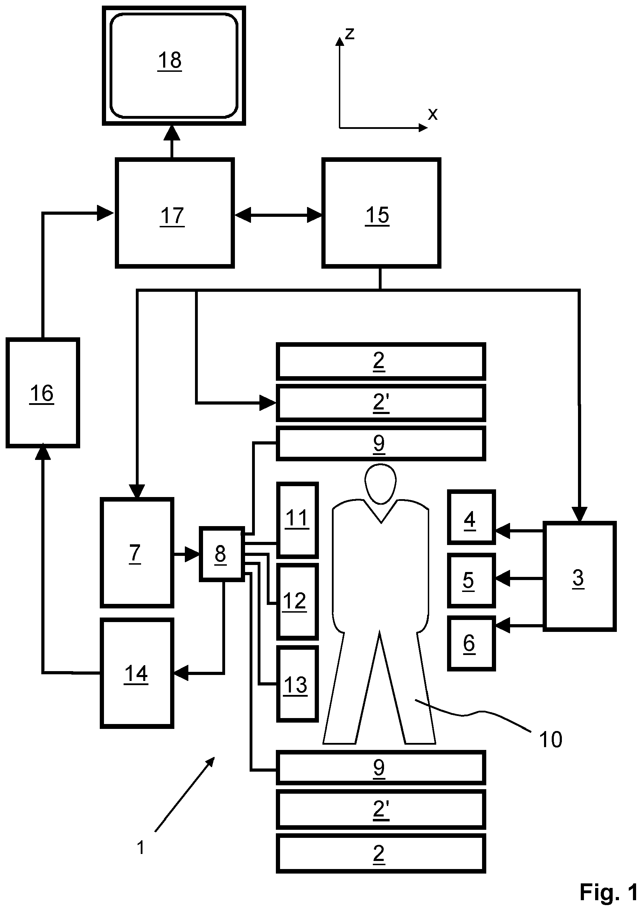

With reference to Fig 1, an MR system 1 is shown as a block diagram. The system comprises superconducting or resistive main magnet coils 2 such that a substantially uniform, temporally constant main magnetic field B₀ is created along a z-axis through an examination volume. The system further comprises a set of (1^{st}, 2^{nd}, and - where applicable - 3^{rd} order) shimming coils 2', wherein the current flow through the individual shimming coils of the set 2' is controllable for the purpose of minimizing B₀ deviations within the examination volume.

A magnetic resonance generation and manipulation system applies a series of RF pulses and switched magnetic field gradients to excite, invert or saturate nuclear magnetic spins, to induce, refocus, or otherwise manipulate magnetic resonance, to spatially or otherwise encode the magnetic resonance, and the like to perform MR imaging.

More specifically, a gradient amplifier 3 applies current pulses or waveforms to selected ones of whole-body gradient coils 4, 5 and 6 along x, y and z-axes of the examination volume. A digital RF frequency transmitter 7 transmits RF pulses or pulse packets, via a send/receive switch 8, to a body RF coil 9 to transmit RF pulses into the examination volume. A typical MR imaging sequence is composed of a packet of RF pulse segments of short duration which, together with any applied magnetic field gradients, achieve a selected manipulation of magnetic resonance. The RF pulses are also used to select a portion of a body 10 positioned in the examination volume. The MR signals are also picked up by the body RF coil 9.

For generation of MR images of limited regions of the body 10 and for scan acceleration by means of parallel imaging, a set of local array RF antennas (coils) 11, 12, 13 are placed contiguous to the region selected for imaging. The array coils 11, 12, 13 can be used to receive MR signals induced by RF transmissions via the body RF coil.

The resultant MR signals are picked up by the body RF coil 9 and/or by the array RF coils 11, 12, 13 and demodulated by a receiver 14 preferably including a preamplifier (not shown). The receiver 14 is connected to the RF coils 9, 11, 12 and 13 via send/receive switch 8.

A host computer 15 controls the shimming coils 2' as well as the gradient pulse amplifier 3 and the transmitter 7 to generate any of a plurality of MR imaging sequences, such as echo planar imaging (EPI), echo volume imaging, gradient and spin echo imaging, fast spin echo imaging, and the like. For the selected sequence, the receiver 14 receives a single MR data line or a plurality of MR data lines in rapid succession following each RF excitation pulse. A data acquisition system 16 performs analog-to-digital conversion of the received signals and converts each MR data line to a digital format suitable for further processing. In modern MR systems the data acquisition system 16 is a separate computer which is specialized in acquisition of raw image data.

Ultimately, the digital raw image data are reconstructed into an image representation by a reconstruction processor 17 which applies a Fourier transform or other appropriate reconstruction algorithms, such as SENSE. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

The host computer 15 and the reconstruction processor 17 are programmed to execute the method of the invention described herein above and in the following.

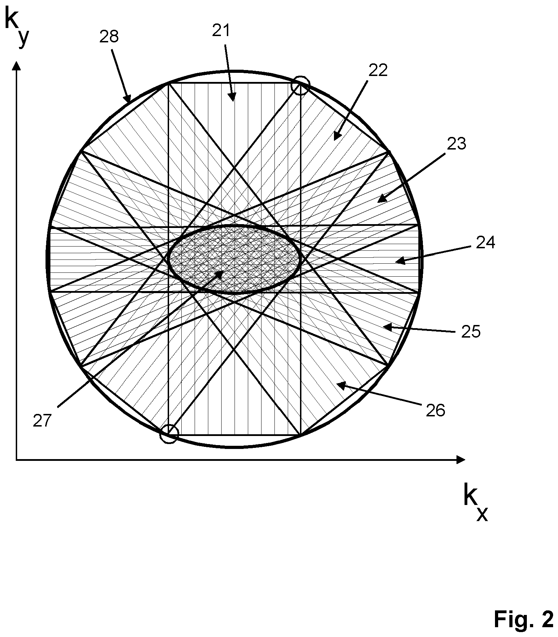

Fig 2 illustrates the k-space sampling according to the adapted PROPELLER MR imaging method according to the invention. As shown in Fig 2, six k-space blades 21-26 are acquired. Each blade 21-26 covers a different portion of k-space, wherein a central elliptical region 27 of k-space is acquired for each blade 21-26. The blades 21-26 are rotated about the center of k-space, so that the total acquired MR data set spans a circle 28 in k-space. Each of the rectangular k-space blades 21-26 comprises 11 parallel and equidistant k-space lines of equal length such that each k-space blade 21-26 provides a homogeneous sampling of the rectangular region covered by the respective blade 21-26. In-plane translation and rotation between the blades 21-26 are detected and corrected like in conventional PROPELLER imaging using, e.g., known similarity measure methods.

The proposed PROPELLER scheme is combined with parallel imaging, which means that at least some of the k-space blades 21-26 are subsampled in the direction perpendicular to the parallel and equidistant k-space lines of each blade, i.e. in the phase-encoding direction of the respective Cartesian k-space sampling pattern. In this case, the k-space resolution is isotropic and the blades are homogeneously subsampled in the phase-encoding direction of the respective Cartesian k-space sampling pattern. As shown in Fig 2, the k-space blades 21-26 have different widths in the respective phase-encoding direction (i.e. transverse to the k-space lines/transverse to the longitudinal extension of the blades). K-space blade 21 is the widest blade. This blade is therefore assigned the lowest sampling density and the highest acceleration factor. k-space blade 26 is the narrowest blade. This blade is therefore assigned the highest sampling density and the lowest acceleration factor. Intermediate values of the sampling density and the acceleration factor are attributed to the remaining k-space blades 22-25. The sampling density increases continuously from the widest k-space blade 21 to the narrowest k-space blade 26. The variation of the width of the k-space blades 21-26 from blade to blade allows to adapt the homogeneous subsampling of each k-space blade 21-26 to the capabilities of the employed RF receiving antennas 11, 12, 13 to support the parallel image reconstruction for the respective orientation of the k-space blade 21-26.

As can further be seen in Fig 2, the variation of the width of the k-space blades 21-26 depending on the rotation angle is determined by the elliptical shape of the common central region 27 of k-space. The long parallel edges of each rectangular k-space blade 21-26 are tangential to the common central region 27 of k-space. Due to the elliptical shape, the k-space blade 24 whose k-space lines are parallel to the semi-major axis of the elliptical region 27 (horizontally oriented in Fig 2) provides the highest sampling density in the phase-encoding direction, while the k-space blade 21 whose k-space lines are parallel to the semi-minor axis of the elliptical region 27 (vertically oriented in Fig 2) provides the lowest sampling density. Accordingly, the directions of the highest and lowest sampling density are perpendicular to each other.

The k-space blades of each pair of adjacent k-space blades 21-26 share two of their vertices lying on the circle 28 in k-space spanned by the set of MR signals. This is illustrated in Fig 2 by the two small circles. The two circles indicate the vertices shared by the k-space blades 21 and 22. The shared vertices are diagonally opposite of each other on each of the blades. This is only shown in Fig 2 for the k-space blades 21 and 22, but applies to all k-space blades 21-26. All adjacent k-space blades 21-26 connect to each other at the outer circumference of the circle 28 with their vertices. Hence, the k-space sampling is performed without overlap and without gaps at the circumference of the circle 28. Consequently, the rotation angle increment between adjacent k-space blades 21-26 varies. Specifically, in Fig 2, the adjacent k-space blades 21 and 22 define a different angle between them than the k-space blades 22 and 23, which in turn define a different angle than the k-space blades 23 and 24. This is in contrast to conventional PROPELLER imaging where a constant increment of the rotation angle is applied.

The parameters determining the elliptical region 27 (lengths and orientations of the semi-major and semi-minor axes in k-space) can be set according to the needs of the respective imaging task in terms of artefact and noise level, depending on the imaged anatomy and the spatial sensitivity profiles of the RF receiving antennas 11, 12, 13 used. In practical applications, the semi-minor axis of the elliptical shape should be oriented in a direction, in which the variation of the spatial sensitivity profiles of the RF receiving antennas 11, 12, 13 is less pronounced than in a direction perpendicular thereto. This means, in other words, that the parameters should be set such that the sampling density is highest for the k-space blade(s) 21-26 for which the conditioning of the parallel image reconstruction is worst (the vertical direction in the example of Fig 2).

Sagittal and coronal knee imaging are illustrative applications of the proposed adapted PROPELLER technique. Typical RF coils for knee imaging support SENSE reconstruction well in the right-left and anterior-posterior directions, but not in the feet-head direction. This is because the major axis of the coil elements is aligned with the feet-head direction, providing only limited variation in sensitivity in this direction. In Cartesian MRI, this is less of a concern, since the readout (frequency-encoding) direction can be chosen to be in feet-head direction such that no subsampling occurs in this direction. The method of the invention can be applied in this example with orienting the semi-minor axis of the elliptical central region 27 in the feet-head direction to enable PROPELLER imaging of the knee in combination with SENSE at a reduced artefact level.

## Claims

1. Method of MR imaging of a body (10) of a patient placed in the examination volume of an MR system (1), the method comprising the steps of:
- generating MR signals by subjecting at least a portion of the body (10) to an MR imaging sequence comprising a number of RF pulses and switched magnetic field gradients;
- acquiring the MR signals in parallel via a number of RF receiving antennas (11, 12, 13) having different spatial sensitivity profiles, wherein the MR-signals are acquired from a plurality of k-space blades (21-26) in temporal succession according to a PROPELLER scheme, wherein the k-space blades (21-26) are rotated about the center of k-space, with the total acquired set of MR signals spanning a circle (28) in k-space and a common central region (27) of k-space being covered by all k-space blades (21-26), the MR-signal acquisition from the respective k-space blades (21-26) involving subsampling of k-space, wherein the density of k-space sampling is varied depending on the rotation angle; and
- computing an MR image by combining the MR signals acquired via the different RF receiving antennas (11, 12, 13) utilizing their spatial sensitivity profiles to perform a parallel image reconstruction.

2. Method of claim 1, wherein the parallel image reconstruction is performed according to the SENSE reconstruction method, alone or in combination with a compressed sensing reconstruction method.

3. Method of claim 1 or 2, wherein each of the k-space blades (21-26) comprises the same number of parallel, equidistant k-space lines,

4. Method of any one of claims 1-3, wherein one k-space blade (24) having a minimum density of k-space sampling is oriented perpendicular to another k-space blade (21) having a maximum density of k-space sampling.

5. Method of any one of claims 1-4, wherein the rotation angle increment between successively acquired k-space blades varies (21-26).

6. Method of any one of claims 1-5, wherein the width of the k-space blades (21-26) varies depending on the rotation angle.

7. Method of claim 6, wherein the variation of the width of the k-space blades (21-26) depending on the rotation angle is determined by an elliptical shape of the common central region (27) of k-space.

8. Method of claim 8, wherein the eccentricity of the elliptical shape is larger than 0.1, preferably larger than 0.2, more preferably larger than 0.5, most preferably larger than 0.7.

9. Method of any one of claims 1-8, wherein the k-space blade having a minimum density of k-space sampling is oriented in a direction, in which the differences between the spatial sensitivity profiles of the RF receiving antennas (11, 12, 13) are less pronounced than in a direction perpendicular thereto, in which the k-space blade having a maximum density of k-space sampling is oriented.

10. Method of any one of claims 1-9, wherein the k-space blade having a minimum density of k-space sampling is oriented in a direction, in which the body of the patient extends the furthest from the center of the examination volume of the MR system (1). 11. Method of any one of claims 1-10, wherein a low-resolution MR image is reconstructed for each k-space blade (21-26) from the MR signals acquired from the common central region (27) of k-space, wherein the low-resolution MR images are compared to each other to estimate and compensate for patient motion.

11. MR system for carrying out the method claimed in claims 1-10, which MR system (1) includes at least one main magnet coil (2) for generating a uniform, steady magnetic field B₀ within an examination volume, a number of gradient coils (4, 5, 6) for generating switched magnetic field gradients in different spatial directions within the examination volume, at least one RF coil (9) for generating RF pulses within the examination volume, a number of RF receiving antennas (11, 12, 13) having different spatial sensitivity profiles for receiving MR signals from a body (10) of a patient positioned in the examination volume, a control unit (15) for controlling the temporal succession of RF pulses and switched magnetic field gradients, and a reconstruction unit (17) for reconstructing MR images from the received MR signals, wherein the MR system (1) is arranged to perform the following steps:
- generating MR signals by subjecting at least a portion of the body (10) to an MR imaging sequence comprising a number of RF pulses and switched magnetic field gradients;
- acquiring the MR signals in parallel via the RF receiving antennas (11, 12, 13), wherein the MR signals are acquired from a plurality of k-space blades (21-26) in temporal succession according to a PROPELLER scheme, wherein the k-space blades (21-26) are rotated about the center of k-space, with the total acquired set of MR signals spanning a circle (28) in k-space and a common central region (27) of k-space being covered by all k-space blades (21-26), the MR-signal acquisition from the respective k-space blades (21-26) involving subsampling of k-space, wherein the density of k-space sampling is varied depending on the rotation angle; and
- computing an MR image by combining the MR signals acquired via the different RF receiving antennas (11, 12, 13) utilizing their spatial sensitivity profiles to perform a parallel image reconstruction.

12. Computer program comprising instructions which, when executed by a control unit (15) of an MR system (1), cause the MR system (1) to carry out the following steps:
- performing an MR imaging sequence comprising a number of RF pulses and switched magnetic field gradients;
- acquiring MR signals in parallel via a number of RF receiving antennas (11, 12, 13), wherein the MR signals are acquired from a plurality of k-space blades (21-26) in temporal succession according to a PROPELLER scheme, wherein the k-space blades (21-26) are rotated about the center of k-space, with the total acquired set of MR signals spanning a circle (28) in k-space and a common central region (27) of k-space being covered by all k-space blades, the MR-signal acquisition from the respective k-space blades (21-26) involving subsampling of k-space, wherein the density of k-space sampling is varied depending on the rotation angle.

13. Computer program comprising instructions which, when executed by a computer, in particular by a reconstruction unit (15) of an MR system (1), cause the computer to compute an MR image from MR signals acquired in parallel via a number of RF receiving antennas (11, 12, 13) having different spatial sensitivity profiles, wherein the MR signals are acquired from a plurality of k-space blades (21-26) in temporal succession according to a PROPELLER scheme, wherein the k-space blades (21-26) are rotated about the center of k-space, with the total acquired set of MR signals spanning a circle (28) in k-space and a common central region (27) of k-space being covered by all k-space blades, the MR-signal acquisition from the respective k-space blades (21-26) involving subsampling of k-space, wherein the density of k-space sampling is varied depending on the rotation angle, and wherein the MR signals acquired via the different RF receiving antennas (11, 12, 13) are combined utilizing their spatial sensitivity profiles to perform a parallel image reconstruction.
